# EUROPEAN PATENT SPECIFICATION

(11) **EP 1 456 436 B1**
(45) Date of publication and mention of the grant of the patent: **16.05.2007**
(21) Application number: 02779571.5
(22) Date of filing: 22.11.2002
(51) Int. Cl.: C30B 25/10, C30B 29/04, C30B 30/08, C23C 16/26

(54) **METHOD FOR PRODUCING PARTICLES WITH DIAMOND STRUCTURE**
VERFAHREN ZUR HERSTELLUNG VON PARTIKELN MIT DIAMANT -STRUKTUR
PROCEDE DE PRODUCTION DE PARTICULES A STRUCTURE DE DIAMANT

(30) Priority: 20.12.2001 EP 01130453
(43) Date of publication of application: 15.09.2004
(73) Proprietor: Max-Planck-Gesellschaft zur Förderung der Wissenschaften e.V. Berlin, 80539 München (DE)
(72) Inventor: DOSE, Volker, 80805 München (DE); MORFILL, Gregor, 81927 München (DE); FORTOV, Vladimir, Moscow, 117993 (RU); SATO, Noriyoshi, Sendai 980-0815 (JP); WATANABE, Yukio, Fukuoka City, Fukuoka Prefecture (JP); THOMAS, Hubertus, M., 85276 Pfaffenhofen/IIm (DE)
(74) Representative: Hertz, Oliver
(86) International application number: PCT/EP2002/013160
(87) International publication number: WO 2003/054257

(56) References cited:
- EP-A- 0 286 310
- EP-A- 0 368 490
- EP-A- 0 407 894
- GB-A- 2 219 578
- JP-A- 2 265 637
- US-A- 4 859 493
- US-A- 5 087 434
- US-B1- 6 238 512
- KATO K ET AL: "ELECTRON TEMPERATURE CONTROL BY VARYING SIZE OF SLITS MADE IN A GRID" APPLIED PHYSICS LETTERS, AMERICAN INSTITUTE OF PHYSICS. NEW YORK, US, vol. 76, no. 5, 31 January 2000 (2000-01-31), pages 547-549, XP000934646 ISSN: 0003-6951 cited in the application
- ISHIKAWA ET AL: "A diagnostic study of plasma CVD under microgravity and its application to diamond deposition" ADV. SPACE RES., vol. 24, no. 10, 1999, pages 1219-1223, XP008003663 cited in the application
- PATENT ABSTRACTS OF JAPAN vol. 013, no. 419 (C-637), 18 September 1989 (1989-09-18) & JP 01 157497 A (NATL INST FOR RES IN INORG MATER), 20 June 1989 (1989-06-20)

## Description

The present invention relates to a method for producing particles having a monocrystalline diamond structure and in particular to a method for vapor-growing of diamond particles under plasma conditions.

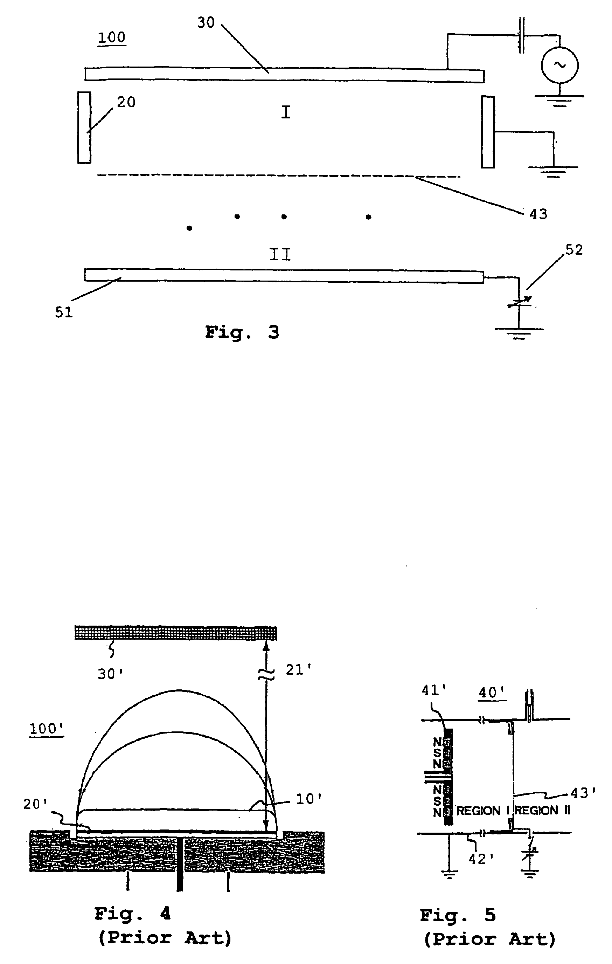

Plasma-assisted Chemical Vapor Deposition (CVD) is generally known. CVD procedures for carbon deposition with diamond structure are investigated since several years. M. Ishikawa et al. describe the plasma-assisted diamond synthesis under microgravity conditions using a plasma chamber which is schematically illustrated in Fig. 4 (M. Ishikawa et al. in "SPIE conference on materials research in low gravity II", SPIE vol. 3792, July 1990, pp. 283-291 and "Adv. Space Res.", vol. 24, 1999, pp. 1219-1223). The plasma chamber 100' contains a substrate 10', an anode 20' and a cathode 30'. The distance 21' between anode and cathode is 1 cm. The plasma chamber is operated in a DC mode under high pressure (about 5 · 10³ Pa). If a mixture of H₂ and CH₄ is supplied to the chamber, carbon with diamond structure can be vapor-grown on the substrate 10'.

The conventional diamond deposition techniques have a plurality of disadvantages, which restrict the practical applicability of the deposited diamonds. An essential disadvantage is the restriction to the thin film formation. The rate of diamond growth is extremely low. The diamond structure is growing into one direction only. The conventional methods could show the appearance of diamonds on the substrate only. However, the thickness of the layers obtained is below the 100 nm range. Furthermore, the layers have a polycrystalline structure only. The effectivity of the diamond growth is further restricted by the use of relatively small substrates with an area of about 20 mm². The prior art procedure does not allow to influence the shape or composition of the carbon layers.

The plasma-assisted diamond layer formation bases in particular on the provision of electrons with a low electron temperature. The electron temperature is a parameter, which describes the average energy distribution of the electrons. According to M. Ishikawa et al., the electron temperature is reduced under the microgravity conditions. A procedure for controlling the electron temperature is described by K. Kato et al. in "Appl. Phys. Lett.", vol. 65, 1994, pp 816-818, and "Appl. Phys. Lett.", vol. 76, 2000, pp 547-549.

The procedure described by K. Kato et al. is implemented with a device which is schematically shown in Fig. 5. The device 40' for producing low temperature electrons (in the following: cold electron source 40') comprises a plasma source 41' surrounded by a chamber wall 42' and a mesh grid 43'. By varying a negative DC potential applied to the grid 43', the electron temperature can be decreased by almost 2 orders of magnitude. A plasma is produced with the plasma source 41' in region I surrounded by the chamber wall 42' and the grid 43'. High energy electrons in the plasma can pass through the grid into the other region II. Ionisation occurs due to the electrons in this region II, resulting in production of cold electrons which are not responsible for maintaining the discharge of the plasma source 41'. With this procedure, an electron temperature in the range of 0.035 eV to 3 eV, e. g. 0.09 eV, can be obtained. The contents of above publications of K. Kato et al., in particular with regard to the operation parameters of the electron temperature control are introduced into the present patent application by reference.

It is a first object of the present invention to provide an improved method for producing particles having a (largely) monocrystalline diamond structure, said method in particular being capable of vapor-growing monocrystalline diamond structure with increased effectiveness, purity and shape. It is a particular object of the present invention to provide a method for producing compact, three-dimensional diamond particles. It is a second object of the invention to provide new particles having a monocrystalline diamond structure, said particles having in particular a predetermined purity, composition and/or shape.

EP 286 310 A1 discloses a process for forming synthetic diamonds by vapor deposition of a carbon gas source in the presence of atomic hydrogen on a substrate contained in a fluidized bed. The substrate is provided by seed particles comprising diamond or other solid materials. GB 2 219 578 A discloses a process for manufacturing diamond particles by depositing in a plasma. The particles obtained with this process have a size of about 10 µm.

These objects are solved by a method or a plasma chamber comprising the features of claim 1, 2, or 11. Advantageous embodiments of the invention are defined in the dependent claims.

According to the invention, at least one particle having a monocrystalline diamond structure is produced by polydirectional vapor-growing of carbon with diamond or tetragonal structure in a reactive plasma. Due to the polydirectional vapor-growing of carbon, the size of a diamond structure is increased simultaneously toward all directions in space. Starting from a seed particle, a diamond structure is grown three-dimensionally. The growing diamond particles are arranged in a space within a reactive plasma. The particles are kept in this space under the influence of external forces compensating gravity. The forces supporting the particles act contact-free so that the whole surface or at least almost the whole surface of each particle is exposed to the reactive plasma and subjected to the vapor-growing process. These measures of the present invention provide the essential advantage of an effective growing process allowing the production of particles with practical shapes up to the cm-range. Contrary to conventional polycrystalline layer deposition methods, a monocrystalline particle is growing all-round on all surfaces, i.e. with a higher growing rate. Due to the influence of gravity compensating forces, the growing process can be maintained even with particle sizes with masses in ng- to mg-range.

According to a first embodiment of the invention, the particles are grown under microgravity or zerogravity conditions. Such conditions are obtained in a plasma chamber which is located in the orbit e.g. on a space vehicle like the International Space Station (ISS) or a satellite. In this situation, the whole chamber and its contents is subjected to centrifugal forces which represent the external gravity compensating forces. Microgravity conditions are present if the gravity is lower than 10⁻³ g, e. g. 10⁻⁴ g. This embodiment has two essential advantages. Firstly, gravity compensating forces are inherently present if the method of the invention is conducted in the orbit. Additional measures for supporting the growing particles are not necessary. In this case, conventional plasma chambers can be used. Secondly, the present inventors have found that particular good results are obtained when the vapor-growing of diamond particles is conducted in a plasma with low temperature electrons. According to the results of M. Ishikawa (see above), an electron temperature reduction is obtained under microgravity or zerogravity conditions. If the method of invention is performed in the orbit, additional measures for reducing the electron temperature can be avoided.

According to a second embodiment 1 and/or of the invention, particles with diamond structure are produced under gravity conditions wherein the external gravity compensating forces comprise thermophoretic forces 1 optical forces. The inventors have realized the possibility of supporting the growing particles in the reactive plasma while the surface of the particles is kept free or almost free. This embodiment of invention has a particular advantage with regard to the implementation under gravity conditions. The plasma chamber can be operated stationary on the earth' surface.

The production of particles having a monocrystalline diamond structure according to the invention allows the production of different particle types. Generally, a particle having a monocrystalline diamond structure is an object, which is covered in all space directions with a diamond layer. The object may consist of carbon completely. Alternatively, the object may contain a core which has been used as a seed particle and which comprises another material than carbon. The core may have a size, which is essentially smaller than the size of the growing particle. Alternatively, the core may have a size which is comparable with the size of the growing particle. In the latter case, the invention provides a compound particle with a non-carbon carrier and a diamond structure deposited all-round on all surfaces of the carrier.

Preferably, the method of the invention is performed in a reactive plasma with low temperature electrons. This feature has an essential advantage with regard to the purity of the obtained diamond particles. The inventors have found that the chemical bonding forming the diamond structure can be obtained with increased reproducibility. With the second embodiment of the invention, the temperature of the electrons is controlled to the range of 0.09 eV to 3 eV.

According to another preferred feature of the invention, the method is conducted in a heated plasma chamber. The method of the invention comprises a thermal control. According to this embodiment, the purity and reproducibility of the particle growth is further improved. Preferably, the temperature of the plasma and growing particles is adjusted to the range of 700°C to 1000°C.

Another subject of the invention is a particle having a diamond structure as such. Particles according to the invention have a diameter of at least 10 µm, preferably at least 100 µm. According to preferred embodiments of the invention, diamond containing particles may have a predetermined shape and/or composition. As an essential advantage, the invention allows the production of so-called adapted or designed diamonds. The diamond structures produced according to the invention are characterized by an extremely high purity which has been proven by Raman spectroscopy experiments.

Another subject of the invention is a plasma chamber being adapted for implementing the above method for producing particles having at least partially a monocrystalline diamond structure. The plasma chamber of the invention in particular comprises a plasma generator with a grid for providing low temperature electrons and a force control device for exerting external gravity compensating forces.

The invention has the following further advantages. The method of producing diamond particles can be implemented with any available plasma production techniques (in particular HF plasma, DC plasma, inductively and/or capacitively coupled plasma, magnetron plasma, microwave plasma, arc plasma). The plasma conditions can be obtained in a broad pressure range covering the available techniques from low pressure to high pressure plasmas (about 10⁻¹ to 10000 Pa). There are no particular restrictions with regard to the reaction gases. The invention can be implemented with any gas containing carbon.

The particles can be grown with an essentially increased growth rate of about 1 µm/h or higher. Contrary to prior art diamond layers which have a polycrystalline diamond structure, the particles of the present invention have a monocrystalline diamond structure. Monocrystals with sizes of at least 10 µm can be obtained.

Further details and advantages of invention are described with reference to the attached drawings. The drawings show in:
- Fig. 1:: a schematic diagram of a plasma chamber used for implementing the method of the present invention,
- Figs. 2, 3:: embodiments of plasma chambers with levitation electrodes,
- Fig. 4:: a schematic illustration of a conventional plasma chamber, and
- Fig. 5:: an illustration of a cold electron source.

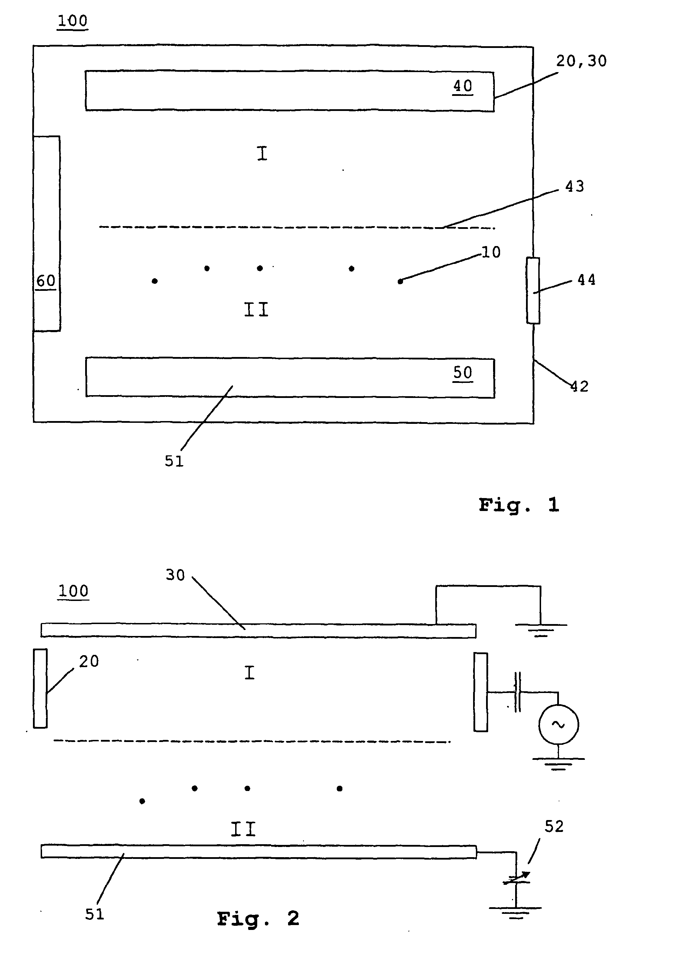

According to the invention, diamond particles are produced in a plasma chamber 100 which is schematically illustrated in Fig. 1. The plasma chamber 100 comprises a plasma generator 40 with electrodes 20, 30 (see below), a grid 43 for electron-temperature control, a force control device 50 for exerting external gravity compensating forces and a temperature control device 60 for controlling the temperature of the plasma chamber 100. These components are arranged in an enclosure 42 which has an e.g. cylindrical shape. The plasma generator 40 and the grid 43 are arranged for producing a reactive plasma in the plasma chamber 100. The plasma chamber 100 is separated into two regions I and II by the grid 43. In region II, a plasma with cold electrons is produced as described above with regard to the prior art cold electron sources. The vapor-growing of diamond particles 10 (schematically shown) is performed in region II as described below. The growing particles can be monitored and analyzed by an appropriate measurement equipment through the monitoring window 44.

It is emphasized that the components 50 and 60 represent features of the plasma chamber 100 which are not necessarily implemented. The force control device 50 can be omitted if the plasma chamber 100 is operated under microgravity or zerogravity conditions. The temperature control device 60 can be omitted if the surrounding temperature of the plasma chamber 100 is high enough for obtaining particles with diamond structure.

The force control device 50 comprises e. g. a levitation electrode 51 (see Figs. 2, 3) or an optical tweezer device. The levitation electrode is arranged for thermophoretic levitating the particles. Thermophoresis has the advantage of a relatively simple structure of the force control device. Furthermore, the levitation electrodes additionally can be used as a temperature control. The use of optical tweezer or electro-static devices provides the capability of controlling the position of single particles. In particular, with an optical tweezer, particular particles can be moved within the plasma.

The plasma chamber 100 comprises further components for supplying the reaction gases, controlling the pressure, delivering seed particles and taking the diamond particles out of the chamber. These components are implemented with control and manipulation devices which are known as such from the conventional plasma and vacuum technology.

Figs. 2 and 3 illustrate plasma chambers 100 with further details. The plasma generator 40 comprises plasma electrodes 20, 30. Plasma electrode 20 has a cylindrical shape surrounding region I of plasma generation. Plasma electrode 30 is a platelike electrode with an outer diameter covering the diameter of cylindrical plasma electrode 20. Both electrodes are made of an appropriate inert material, e. g. stainless steel. The diameter of plasma electrode 20 is about 10 cm. The axial height of plasma electrode 20 is about 5 cm. The dimension of plasma chamber 100 or the components thereof generally may be selected like dimensions of conventional plasma chambers. However, the plasma chamber of the invention can be provided with other dimensions depending on the application.

While region I is delimited on one side by plasma electrode 30, the other side is covered with the grid 43 for electron-temperature control. The grid is made e. g. from stainless steel with a mesh size of 0.1-1.2 meshes/mm. Grid 43 has a negative DC potential so that it functions as a filter for electrons leaving region I.

Plasma electrodes 20 and 30 can be operated for producing a radio frequency plasma. The cylindrical plasma electrode 20 may be the radio frequency electrode (see Fig. 2) or grounded (see Fig. 3) while the other electrode 30 is the counter electrode. Details of the plasma generation are not described here as they are known as such.

The levitation electrode 51 is arranged with an axial distance from the grid 43 of about 5 cm. Electrode 51 is made of a plate or a grid which is heated for generating a thermophoretic flow inside region II. The temperature of levitation electrode 51 is adjusted with a control device 52.

Preferably, the method of the present invention follows the following procedural steps. Firstly, the plasma chamber 100 is operated as it is known from a plasma technology. A reactive gas is supplied to the plasma chamber. The reaction gas comprises e. g. a mixture of H₂ and CH₄. Preferably, the contents of CH₄ is selected in the range of 1 to 10%. Other possible mixtures of reactive gas are CH₃OH C₂H₅OH, C₂H₂, CO₂, CO. The pressure of the reaction gas is adjusted to be in the range of 10⁻¹ Pa to 100 Pa. The low pressure regime is preferred under gravity conditions. Furthermore, the temperature of the plasma chamber 100 is adjusted to be in the range of 700°C to 1000°C. The temperature is controlled by the temperature control 60 electrically.

Secondly, seed particles are provided in the plasma chamber 100, in particular in region II with cold electron plasma. Basically, the seed particle formation may be implemented according to one of the following approaches. For an "in situ growing", seed particles are formed spontaneously in the plasma. The density of spontaneous seed particle formation can be controlled. Alternatively, seed particles are supplied externally to the plasma chamber. This seed particle supply is preferred if the method of the invention is performed under gravity conditions. As seed particles, microscopic diamond particles, conducting particles or non-conducting particles are supplied. The use of diamond particles has the particular advantage of providing a substrate with the lattice structure to be grown. Non-conducting particles (e. g. ceramic particles) or conducting metallic particles (e. g. Ni) have the advantage of improved levitation control. Furthermore, they can be supplied with certain shapes or sizes so that the shape or size of the growing diamond structure can be influenced.

In the following, carbon from the reactive gas is polydirectionally grown to the seed particles. Carbon is deposited all-round on all surfaces of the particles. During the growth process, the masses of the particles are increased. In conventional processes, particles can occur as an undesired distortion. These particles can grow until a size of about 40 µm. Bigger particles fall down under the influence of gravity. Contrary to these effects, the present invention allows particle growth into the range of 50 µm and higher, e. g. from 100 µm up to the cm range. Under microgravity or zerogravity conditions, particle sizes of e. g. 3 cm can be obtained.

The method of the invention can be modified as follows. According to an embodiment of the invention, the shape of diamond particles is controlled by providing seed particles with a predetermined shape and/or by controlling the plasma conditions during the growth process. As an example, seed particles with whisker shape or loop shape are used. Furthermore, additional plasma control electrodes can be provided in the plasma chamber 100. These electrodes may be adapted for generating electro-static or magnetic fields in particular in region II so that a preferred growth direction is obtained.

The composition of diamond particles can be controlled by an additional substance supply. During the growth process, doping impurities can be added for obtaining special features of the diamond particles as e. g. colors or other optical properties. Doping impurities are, as an example, dyes or metals. Doping impurities be may added as a beam of molecules or atoms or alternatively as powder. The obtained compositions have the particular advantage of comprising properties of the diamond as well as the doping impurity. This offers a new dimension for the design of functional materials.

The arrangement of the plasma generator 40 and the grid 43 within the plasma chamber 100 can be modified depending on the particular operation conditions. Under microgravity or zero-gravitiy conditions, the plasma chamber can be arranged in any space direction. Under gravity conditions, the plasma generator can be arranged on a side wall or on the bottom of the plasma chamber. The force control device may comprise a mechanical support for the seed particles and the growing diamond particles. The mechanical support comprises e. g. a plurality of filaments or wires which are fixed in the plasma chamber. The ends of the filaments project into the region with low electron temperature plasma. In this situation, the growing of diamond structure on the free surface of the particles is possible. The diameter of the filament is e. g. 1-2 µm.

## Claims

1. Method for producing particles having a monocrystalline diamond structure, comprising the steps of:
- operating a plasma chamber (100) containing a reaction gas with at least one carbon compound and generating a reactive plasma,
- providing seed particles in said plasma chamber (100), and
- polydirectional growing carbon with diamond structure on said seed particles, so that growing diamond containing particles are formed,
**characterized in that**
- said plasma chamber (100) is operated under microgravity or zerogravity conditions.

2. Method for producing particles having a monocrystalline diamond structure, comprising the steps of:
- operating a plasma chamber (100) containing a reaction gas with at least one carbon compound and generating a reactive plasma, wherein said plasma chamber (100) is operated under gravity conditions,
- providing seed particles in said plasma chamber (100) which are arranged under the influence of external gravity compensating forces within the reactive plasma, and
- polydirectional growing carbon with diamond structure on said seed particles, so that growing diamond containing particles are formed,
**characterized in that**
- said seed particles and/or diamond containing particles are supported within the reactive plasma by thermophoretic forces and/or optical forces, and
- the temperature of the electrons in said plasma is controlled to be reduced to the range of 0.09 eV to 3 eV.

3. Method according to claim 1 or 2, wherein said seed particles are formed in said reactive plasma or supplied externally.

4. Method according to claim 3, wherein said seed particles consist of a non-carbon material.

5. Method according to claim 4, wherein said diamond containing particles are compound particles with a carrier covered with a monocrystalline diamond layer.

6. Method according to claim 1 or 2, wherein the pressure of the reaction gas is adjusted to be in the range of 0.13 Pa (10⁻³ T) to 133 Pa (1 T).

7. Method according to claim 1 or 2, wherein said plasma chamber is temperature controlled in the range of 700°C to 1000°C.

8. Method according to one of the forgoing claims, wherein at least one doping impurity is supplied to the reactive plasma while said diamond containing particles are grown.

9. Method according to one of the forgoing claims, wherein said diamond containing particles are grown with a size above 50 µm up to the cm range.

10. Method according to claim 9, wherein said diamond containing particles are grown with a size above 100 µm up to the cm range.

11. Plasma chamber being adapted to produce particles having a monocrystalline diamond structure, said plasma chamber comprising:
- a plasma generator (40) for generating a reactive plasma,
- a grid (43) for generating a plasma with a reduced electron temperature, and
- a force control device (50) for providing gravity compensating forces levitating particles in said plasma with reduced electron temperature
**characterized in that**
said force control device (50) comprises at least one levitating electrode (51) for thermophoretic levitating particles in
said plasma with reduced electron temperature or an optical tweezer device.

## Patentansprüche

1. Verfahren zur Herstellung von Partikeln, die eine monokristalline Diamantstruktur aufweisen, umfassend die Schritte:
- Betreiben einer Plasmakammer (100), die ein Reaktionsgas mit mindestens einer Kohlenstoffverbindung enthält, und Erzeugen eines reaktiven Plasmas,
- Bereitstellen von Keimpartikeln in der Plasmakammer (100), und
- polydirektionales Wachsen von Kohlenstoff mit Diamantstruktur auf den Keimpartikeln, so dass wachsende, Diamant enthaltende Partikel gebildet werden,
**dadurch gekennzeichnet, dass**
- die Plasmakammer (100) unter Mikrogravitations- oder Schwerelosigkeits-Bedingungen betrieben wird.

2. Verfahren zur Herstellung von Partikeln, die eine monokristalline Diamantstruktur aufweisen, umfassend die Schritte:
- Betreiben einer Plasmakammer (100), die ein Reaktionsgas mit mindestens einer Kohlenstoffverbindung enthält, und Erzeugen eines reaktiven Plasmas, wobei die Plasmakammer (100) unter Gravitationsbedingungen betrieben wird,
- Bereitstellen von Keimpartikeln in der Plasmakammer (100), die unter dem Einfluss äußerer gravitationskompensierender Kräfte in dem reaktiven Plasma angeordnet werden, und
- polydirektionales Wachsen von Kohlenstoff mit Diamantstruktur auf den Keimpartikeln, so dass wachsende, Diamant enthaltende Partikel gebildet werden,
**dadurch gekennzeichnet, dass**
- die Keimpartikeln und/oder die Diamant enthaltenden Partikel in dem reaktiven Plasma durch thermophoretische Kräfte und/oder optische Kräfte gehalten werden, und
- die Temperatur der Elektronen in dem Plasma gesteuert wird, um auf den Bereich von 0.09 eV bis 3 eV reduziert zu werden.

3. Verfahren gemäß Anspruch 1 oder 2, bei dem die Keimpartikel in dem reaktiven Plasma gebildet oder extern zugeführt werden.

4. Verfahren gemäß Anspruch 3, bei dem die Keimpartikel aus einem Nicht-Kohlenstoff-Material bestehen.

5. Verfahren gemäß Anspruch 4, bei dem die Diamant enthaltenden Partikel Zusammensetzungspartikel mit einem Träger sind, der mit einer monokristallinen Diamantschicht bedeckt ist.

6. Verfahren gemäß Anspruch 1 oder 2, bei dem der Druck des Reaktionsgases in dem Bereich von 0.13 Pa (10⁻³ T) bis 133 Pa (1 T) eingestellt wird.

7. Verfahren gemäß Anspruch 1 oder 2, bei dem die Plasmakammer im Bereich von 700°C bis 1000°C temperaturgesteuert ist.

8. Verfahren gemäß einem der vorhergehenden Ansprüche, bei dem mindestens ein Dotierfremdstoff dem reaktiven Plasma zugeführt wird, während die Diamant enthaltenden Partikel wachsen.

9. Verfahren gemäß einem der vorhergehenden Ansprüche, bei dem die Diamant enthaltenden Partikel mit einer Größe oberhalb 50 µm bis in den cm-Bereich gewachsen werden.

10. Verfahren gemäß Anspruch 9, bei dem die Diamantenthaltenden Partikel mit einer Größe oberhalb 100 µm bis in den cm-Bereich gewachsen werden.

11. Plasmakammer, die zur Herstellung von Partikeln eingerichtet ist, die eine monokristalline Diamantstruktur aufweisen, wobei die Plasmakammer umfasst:
- einen Plasmagenerator (40) zur Erzeugung eines reaktiven Plasmas,
- ein Gitter (43) zur Erzeugung eines Plasmas mit einer verringerten Elektronentemperatur, und
- eine Kraftsteuereinrichtung (50) zur Bereitstellung von gravitations-kompensierenden Kräften, die Partikel in dem Plasma mit verringerter Elektronentemperatur levitieren,
**dadurch gekennzeichnet, dass**
die Kraftsteuereinrichtung (50) mindestens eine levitierende Elektrode (51) zum thermophoretischen Levitieren von Partikeln in dem Plasma mit verringerter Elektronentemperatur oder eine optische Pinzetteneinrichtung umfasst.

## Revendications

1. Procédé de production de particules ayant une structure de diamant microcristallin, comprenant les étapes consistant à :
- faire fonctionner une chambre à plasma (100) contenant un gaz de réaction avec au moins un composé carboné et générant un plasma réactif,
- introduire des particules de semences à l'intérieur de ladite chambre à plasma (100), et
- faire croître dans plusieurs directions du carbone ayant une structure de diamant sur lesdites particules de semences de telle sorte que des particules contenant du diamant en croissance soit formées,
**caractérisé en ce que**
- ladite chambre à plasma (100) fonctionne dans des conditions de microgravité ou de gravité zéro.

2. Procédé de production de particules ayant une structure de diamant microcristallin, comprenant les étapes consistant à :
- faire fonctionner une chambre à plasma (100) contenant un gaz de réaction avec au moins un composé carboné et générant un plasma réactif, dans lequel ladite chambre à plasma (100) fonctionne dans des conditions de gravité,
- introduire des particules de semences à l'intérieur de ladite chambre à plasma (100), qui sont arrangées sous l'influence de forces de compensation de gravité externe à l'intérieur du plasma réactif, et
- faire croître dans plusieurs directions du carbone ayant une structure de diamant sur lesdites particules de semences de telle sorte que des particules contenant du diamant en croissance soit formées,
**caractérisé en ce que**
- lesdites particules de semences et / ou lesdites particules contenant du diamant en croissance, sont supportées à l'intérieur du plasma réactif par des forces thermophorétiques et / ou des forces optiques, et
- la température des électrons dans ledit plasma est régulée pour être réduite à une plage de 0,09 eV à 3 eV.

3. Procédé selon la revendication 1 ou 2, dans lequel lesdites particules de semences sont formées dans ledit plasma réactif ou fournies de manière externe.

4. Procédé selon la revendication 3, dans lequel lesdites particules de semences sont constituées en un matériau autre que du carbone.

5. Procédé selon la revendication 4, dans lequel lesdites particules contenant du diamant sont des particules composées avec une couche de support recouverte d'une couche de diamant monocristallin.

6. Procédé selon la revendication 1 ou 2, dans lequel la pression du gaz de réaction est ajustée pour se situer dans la plage de 0,13 Pa (10⁻³ T) et 133 Pa (1 T).

7. Procédé selon la revendication 1 ou 2, dans lequel la température de ladite chambre à plasma est régulée dans une plage de 700° C. à 1000° C.

8. Procédé selon l'une quelconque des revendications précédentes, dans lequel au moins une impureté de dopage est ajoutée au plasma réactif pendant que les particules contenant du diamant sont mises en croissance.

9. Procédé selon l'une quelconque des revendications précédentes, dans lequel lesdites particules contenant du diamant sont mises en croissance avec une taille de plus de 50 µm jusqu'à la plage des centimètres.

10. Procédé selon la revendication 9, dans lequel lesdites particules contenant du diamant sont mises en croissance avec une taille de plus de 100 µm jusqu'à la plage des centimètres.

11. Chambre à plasma adaptée pour produire des particules ayant une structure de diamant monocristallin, ladite chambre à plasma comprenant :
- un générateur de plasma (40) pour générer un plasma réactif,
- une grille (43) pour générer un plasma ayant une température d'électrons réduite, et
- un dispositif de contrôle de forces (50) pour fournir des forces de compensation de gravité pour fournir aux particules en lévitation dans ledit plasma une température d'électrons réduite
**caractérisé en ce que**
ledit dispositif de contrôle de forces (50) comprend au moins une électrode de lévitation (51) pour des particules en lévitation thermophorétique dans ledit plasma avec une température d'électrons réduite ou un dispositif formant pince optique.
